# EUROPEAN PATENT APPLICATION

(11) **EP 2 392 935 A1**
(43) Date of publication of application: **07.12.2011**
(21) Application number: 10164842.6
(22) Date of filing: 03.06.2010
(51) Int. Cl.: G01R 33/54, G01R 33/561, G01R 33/565

(54) **EPI distortion correction using non-phase encoded reference echoes**

(71) Applicant: Koninklijke Philips Electronics N.V., 5621 BA Eindhoven (NL)
(72) Inventor: Brink, Van den, Johan, S., 5600 AE Eindhoven (NL); Koonen, Jos, 5600 AE Eindhoven (NL)
(74) Representative: Damen, Daniel Martijn

(57) **Abstract**

The invention relates to a method of acquiring a magnetic resonance image of an object (10) in a main magnetic field of a magnetic resonance scanner, the method comprising:
- performing (200) an echo planar imaging reference scan on the object (10), wherein said reference scan is acquired without phase encoding, said reference scan resulting in a set of gradient echoes,
- storing (202) the set of gradient echoes from said reference scan as a reference dataset for each gradient echo time point,
- performing (204) for each gradient echo time point a 1D Fourier transform of the reference dataset in the frequency encoding direction, said Fourier transforms resulting in a phase navigator vector for each gradient echo time point,
- performing (208) an echo planar imaging scan on the object (10), wherein said scan is acquired with phase encoding for each of the gradient echo time points, said echo planar imaging scan resulting in an image formation dataset,
- performing (210) for each of the gradient echo time points a 1D Fourier transform of the image formation dataset in the frequency encoding direction, said Fourier transforms resulting in a phase encoded image vector for each gradient echo time point,
- calculating (212, 218) corrected phase encoded image vectors for each gradient echo time point, said calculation comprising subtracting for each given gradient echo time point the phase of the phase navigator vector from the phase of the phase encoded image vector.

## Description

### FIELD OF THE INVENTION

The invention relates to a method of acquiring a magnetic resonance image of an object, a computer program product, as well as a magnetic resonance imaging system for acquiring a magnetic resonance image of an object.

### BACKGROUND OF THE INVENTION

Image-forming MR methods, which utilize the interaction between magnetic field and nuclear spins in order to form two-dimensional or three-dimensional images are widely used nowadays, notably in the field of medical diagnostics, because for the imaging of soft tissue they are superior to other imaging methods in many respects, they do not require ionizing radiation, and they are usually not invasive.

According to the MR method in general, the body of a patient or in general an object to be examined is arranged in a strong, uniform magnetic field B₀ whose direction at the same time defines an axis, normally the z-axis, of the coordinate system on which the measurement is based.

The magnetic field produces different energy levels for the individual nuclear spins in dependence on the applied magnetic field strength which spins can be excited (spin resonance) by application of an alternating electromagnetic field (RF field) of defined frequency, the so called Larmor frequency or MR frequency. From a macroscopic point of view the distribution of the individual nuclear spins produces an overall magnetization which can be deflected out of the state of equilibrium by application of an electromagnetic pulse of appropriate frequency (RF pulse) while the magnetic field extends perpendicularly to the z-axis, so that the magnetization performs a precessional motion about the z-axis.

Any variation of the magnetization can be detected by means of receiving RF antennas, which are arranged and oriented within an examination volume of the MR device in such a manner that the variation of the magnetization is measured in the direction perpendicularly to the z-axis.

In order to realize spatial resolution in the body, constant magnetic field gradients extending along the three main axes are superposed on the uniform magnetic field, leading to a linear spatial dependency of the spin resonance frequency. The signal picked up in the receiving antennas then contains components of different frequencies which can be associated with different locations in the body.

The signal data obtained via the receiving antennas corresponds to the spatial frequency domain and is called k-space data. The k-space data usually includes multiple lines acquired with different phase encoding. Each line is digitized by collecting a number of samples. A set of samples of k-space data is converted to an MR image, e.g. by means of Fourier transformation.

A popular sequence for acquiring magnetic resonance images is Echo Planar Imaging (EPI). EPI has the advantage that in a rapid manner images can be acquired which helps for example to reduce motion related artefacts and problems in MR images.

A major problem to EPI imaging is that respective EPI images often have significant distortions due to local variations of the main magnetic field (B₀), which cause for example problems to overlay such EPI images onto for example T₂-TSE or T₁-FFE images. In addition, local variations of B₀ cause resolution losses.

There are various solutions to this problem which however themselves each have major disadvantages. One known solution is for example to acquire full k-space datasets for each gradient echo in the EPI echo train and correct the phase of each gradient echo k_{y} line, or shift the image with the corresponding B₀ map. A disadvantage here is that this adds a long scan time to acquire multiple full k-spaces; for example 128 echoes require 128 extra phase echoes which results in several minutes additional scan time.

An alternative solution to the problem is to acquire a separate B₀ map and correct the image, or adjust the k-space location phase. However, there may be a movement between the separate B₀ map and the EPI scan which results in resolution differences between the B₀ map and the EPI scan. A further solution is an elastic registration of the EPI images onto the anatomical images, as well as to acquire EPI data with opposite phase encoded directions and register those datasets. However, this does not provide a solution for resolution losses.

Further, for example US7,098,662 B2 discloses a method and system of MR imaging where variable readout gradient filtering is carried out after MR data acquired during gradient field transitions has been phase corrected.

From the foregoing it is readily appreciated that there is a need for an improved EPI distortion correction. It is consequently an object of the invention to provide a method which enables EPI distortion correction in a highly effective manner.

### SUMMARY OF THE INVENTION

In accordance with the invention, a method of acquiring a magnetic resonance image of an object in a main magnetic field of a magnetic resonance scanner is provided, wherein the method comprises performing an echo planar imaging reference scan on the object, wherein said reference scan is acquired without phase encoding, said reference scan resulting in a set of gradient echoes. Then, the set of gradient echoes from said reference scan is stored as a reference dataset for each gradient echo time point. This is followed by performing for each gradient echo time point a 1D Fourier transform of the reference dataset in the frequency encoding direction, wherein said Fourier transforms result in a phase navigator vector for each gradient echo time point.

Then, an echo planar imaging scan on the object is performed, wherein said scan is acquired with phase encoding for each of the gradient echo time points, wherein said echo planar imaging scan results in an image formation dataset. For each of the gradient echo time points a 1D Fourier transform of the image formation dataset in the frequency encoding direction is performed, said Fourier transforms resulting in a phase encoded image vector for each gradient echo time point. Finally, corrected phase encoded image vectors are calculated for each gradient echo time point, said calculation comprising subtracting for each given gradient echo time point the phase of the phase navigator vector from the phase of the phase encoded image vector.

In other words, data from an EPI phase correction reference scan are used to correct for the average phase per gradient echo time point. Since this reference scan is always acquired to derive the gradient encoding differences for odd and even echoes, the method does not add any scan preparation time. However, in a highly reliable manner EPI distortion correction can be provided.

Each gradient echo in the EPI phase correction reference scan is non-phase encoded (i.e. a k=0 profile, or 1D projection along the y-direction for each x-position, after Fourier transform along x).

In accordance with an embodiment of the invention, the method further comprises Fourier transforming the corrected phase encoded image vectors which results in a final magnetic resonance image of the object.

In accordance with a further embodiment of the invention, the method further comprises smoothing the phase of the phase navigator vector, wherein smoothing comprises fitting the phases of the set of the phase navigator vectors for different gradient echo time points and smoothing the phases of the phase navigator vectors by the fit. Preferably in the fit, the phase of the gradient echo with smallest main magnetic field induced phase error is kept here and modified.

By phase smoothing, noise and phase uncertainties can be removed which further improves the EPI distortion correction of images. Rapidly varying phase changes due to for example flow and motion are suppressed by this smoothing process, which applies the prior knowledge that phase due to global field inhomogeneities is characterized by slow variations. Any rapid variations in space are thus considered artifactual, and can be smoothed by polynomial fitting or similar numerical techniques. In addition, phase variation over the echoes representing evolution of phase over time can be constrained by imposing a phase evolution constraint representing small field offsets (phase being γ*ΔB0*ΔTE).

In accordance with a further embodiment of the invention, the reference scan is based on a spin echo or gradient echo excitations. The spin echo EPI readout is typically applied for diffusion imaging in brain and body, as well as for arterial spin labeling experiments. The gradient echo EPI readout is especially suited for measurements of brain function based on temporal variations in brain oxygenation.

In accordance with a further embodiment of the invention, the magnetic resonance image data acquisition is performed by parallel imaging employing multiple receiving coil elements, wherein the calculation of the corrected phase encoded image vector is performed per coil element. This further speeds up the data acquisition process.

In accordance with a further embodiment of the invention, the method further comprises calculating new corrected phase encoded image vectors for each coil element, said calculation comprising adding the coil phase to the phases of the corrected phase encoded image vectors calculated for said coil element. First of all, this permits performing for example a SENSE reconstruction, wherein the above mentioned phase correction, applied on the SENSE folded images, will reduce the geometric distortion so that SENSE EPI unfolding is more robust. This also applies to other parallel imaging reconstruction strategies.

In accordance with a further embodiment of the invention, retaining the coil phase comprises for each coil element determining for a given coil element the gradient echo of the set of gradient echoes with the smallest main magnetic field induced phase error and adding the phase of said determined gradient echo to each other phase of the corrected phase encoded image vectors calculated for said coil element, said adding resulting in the new corrected phase encoded image vectors.

This permits in a highly effective manner to remove geometric distortions while keeping the overhead of phase estimation and the effort of phase correction to a minimum.

In accordance with a further embodiment of the invention, the steps of calculating the corrected phase encoded image vectors and calculating the new corrected phase encoded image vectors are performed by calculating for each gradient echo time point the difference between the phase of the phase navigator vector of said gradient echo at said echo time point and the phase of the phase navigator vector of the determined gradient echo with the smallest main magnetic field induced phase error, said calculation resulting in a phase difference for each echo time point, and adding at each echo time point said phase difference to the corresponding phase of the phase encoded image vector, said adding resulting in the new corrected phase encoded image vectors.

Preferably, in case the reference scan is based on spin echo excitations, the gradient echo at a spin echo readout time is selected as the gradient echo with the smallest main magnetic field induced phase error. In contrast, in case the reference scan is based on gradient echo excitations, the earliest gradient echo with the shortest echo time is selected as the gradient echo with the smallest main magnetic field induced phase error, preferably.

In accordance with a further embodiment of the invention, said reference scan is acquired for subsequent gradient echo time points in opposite k-space directions.

In accordance with a further embodiment of the invention, the method further comprises performing the echo planar imaging reference scan employing fat suppression, wherein the set of gradient echoes with fat suppression are used for the calculation of the phase navigator vectors.

In detail, the method may for example comprise:
- performing the echo planar imaging reference scan twice for different echo times resulting in two sets of gradient echoes,
- performing water/fat unfolding employing the two sets of gradient echoes, said unfolding resulting in a new set of gradient echoes,
- using said new set of gradient echoes for calculation of the phase navigator vectors,
- performing the echo planar imaging scan on the object resulting in the image formation dataset,
- performing the 1D Fourier transform of the image formation dataset,
- calculating the corrected phase encoded image vectors for each gradient echo time point, said calculation comprising subtracting for each given gradient echo time point the phase of the new phase navigator vector from the phase of the phase encoded image vector.

However, it has to be noted here, that instead of the described DIXON water/fat separation approach, any method can be employed which permits fat suppression in the reference scan - either using spectrally-selective or inversion time selective pulses to null the fat signal or by Dixon imaging wherein the method is performed to derive phase errors for the water signal only by computationally removing the fat component.

In another aspect, the invention relates to a computer program product comprising computer executable instructions to perform the method as described above.

In another aspect, the invention relates to a magnetic resonance imaging system for acquiring a magnetic resonance image of an object in an examination volume of a magnetic resonance scanner, said scanner comprising a main magnet for providing a main magnetic field within the examination volume, wherein the system is adapted for:
- performing an echo planar imaging reference scan on the object, wherein said reference scan is acquired without phase encoding, said reference scan resulting in a set of gradient echoes,
- storing the set of gradient echoes from said reference scan as a reference dataset for each gradient echo time point,
- performing for each gradient echo time point a 1D Fourier transform of the referenced dataset in the frequency encoding direction, said Fourier transforms resulting in a phase navigator vector for each gradient echo time point,
- performing an echo planar imaging scan on the object, wherein said scan is acquired with phase encoding for each the gradient echo time points, said echo planar imaging scan resulting in an image formation dataset,
- performing for each of the gradient echo time points 1D Fourier transform of the image formation dataset in the frequency encoding direction, said Fourier transforms resulting in a phase encoded image vector for each gradient echo time point,
- calculating corrected phase encoded image vectors for each gradient echo time point, said calculation comprising subtracting for each given gradient echo time point a phase of the phase navigator vector from the phase of the phase encoded image vector.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR device for implementation of the method according to the invention,
Fig. 2 illustrates a flowchart for performing an EPI distortion correction,
Fig. 3 shows a simulation result for EPI distortion correction of an MR image.

### DETAILED DESCRIPTION OF SOME EMBODIMENTS OF THE INVENTION

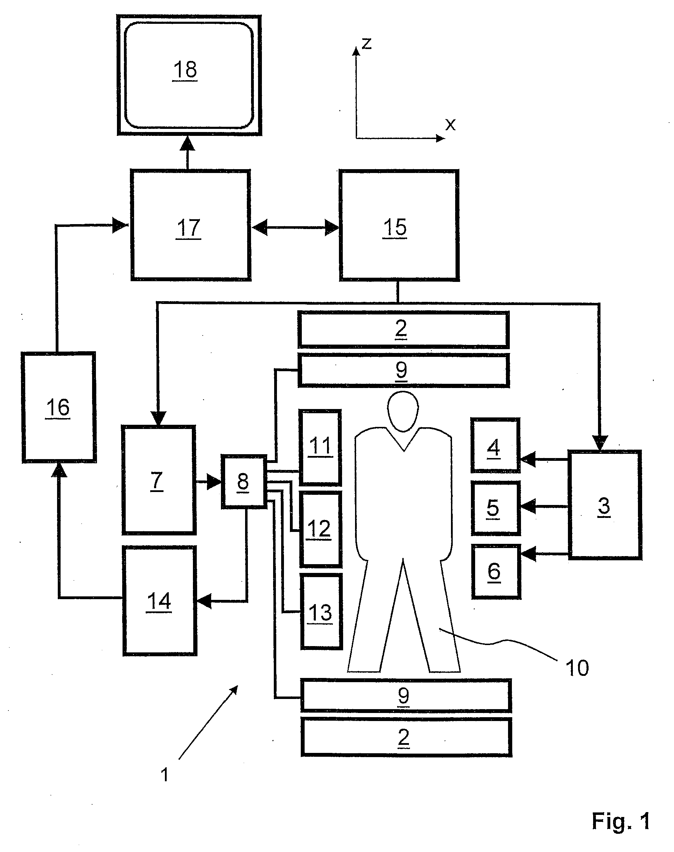

With reference to Fig. 1, an MR imaging system 1 is shown. The system comprises superconducting or resistive main magnet coils 2 such that a substantially uniform, temporarily constant main magnetic field B₀ is created along a z-axis through an examination volume.

A magnetic resonance generation manipulation system applies a series of RF pulses and switched magnetic field gradients to invert or excite nuclear magnetic spins, induce magnetic resonance, refocus magnetic resonance, manipulate magnetic resonance, spatially or otherwise encode the magnetic resonance, saturate spins and the like to perform MR imaging.

More specifically, a gradient pulse amplifier 3 applies current pulses to selected ones of whole body gradient coils 4, 5 and 6 along x, y and z-axes of the examination volume. An RF transmitter 7 transmits RF pulses or pulse packets, via a send/receive switch 8 to an RF antenna 9 to transmit RF pulses into the examination volume. A typical MR imaging sequence is composed of a packet of RF pulse sequences of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals may also be picked up by the RF antenna 9.

For generation of MR images of limited regions of the body or in general object 10, for example by means of parallel imaging, a set of local array RF coils 11, 12 and 13 are placed contiguous to the region selected for imaging. The array coils 11, 12 and 13 can be used to receive MR signals induced by RF transmissions effected via the RF antenna. However, it is also possible to use the array coils 11, 12 and 13 to transmit RF signals to the examination volume.

The resultant MR signals are picked up by the RF antenna 9 and/or by the array of RF coils 11, 12 and 13 and are demodulated by a receiver 14 preferably including a pre-amplifier (not shown). The receiver 14 is connected to the RF coils 9, 11, 12 and 13 via a send/receive switch 8.

A host computer 15 controls the gradient pulse amplifier 3 and the transmitter 7 to generate any of a plurality of imaging sequences, such as echo planar imaging (EPI), echo volume imaging, gradient and spin echo imaging, fast spin echo imaging and the like.

For the selected sequence, the receiver 14 receives a single or a plurality of MR data lines in a rapid succession following each RF excitation pulse. A data acquisition system 16 performs analogue to digital conversion of the received signals and converts each MR data line to a digital format suitable for further processing. In modem MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume or the like. The image is then stored in an image memory where it may be accessed for converting slices or other portions of the image representation into appropriate formats for visualization, for example via a video monitor 18 which provides a man readable display of the resultant MR image.

The host computer 15 may be for example adapted for generating respective EPI sequences in order to carry out the method described above, whereas the reconstruction processor 17 may be adapted for performing the respective Fourier transforms, as well as mathematical calculations to determine the final desired magnetic resonance image of the object 10.

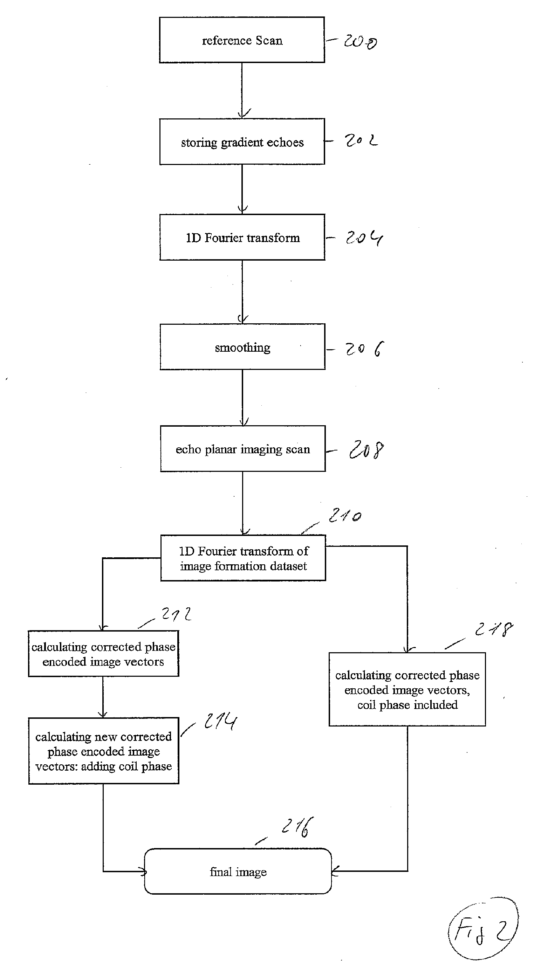

Fig. 2 illustrates a flowchart of the method according to the invention. The method starts in step 200 with the performance of an echo planar imaging reference scan on an object to be scanned, wherein said scan is acquired without phase encoding. The resulting gradient echoes are stored in step 202 in a respective memory. Then, in step 204, a 1D Fourier transform of the stored gradient echoes is performed for each gradient echo time point in the frequency encoding direction. The Fourier transforms of step 204 result in multiple phase navigator vectors for each gradient echo time point.

This is followed by the optional step 206, in which a smoothing of the phases *P_{0..n}* of the phase navigator vectors obtained in step 204 is performed.

Either directly after step 204 or after having performed additionally step 206, the method commences with step 208 in which an EPI scan on the object is performed, wherein the EPI scan is performed with phase encoding for each of the gradient echo time points for which the reference scan has been made. Said echo planar imaging scan then results in an image formation dataset.

In step 210, for each of the gradient echo time points obtained from step 208 a 1D Fourier transform of the image formation dataset in the frequency encoding direction is performed, wherein said Fourier transforms result in phase encoded image vectors for the gradient echo time points.

In case a single receiving coil element is used, i.e. in the case no parallel imaging is applied, the method continues with step 212 in which a corrected phase encoded image vector for each gradient echo time points are calculated, said calculation comprising subtracting for each given gradient echo time point the phase *P_{0..n}* of the phase navigator vector obtained in step 204 (optional step 206) from the phase *I_{0..n}* of the phase encoded image vectors obtained in step 210, i.e. the corrected phases read as *C_{0..n} ⁼ I_{0..n}⁻ P_{0..n}.*

In the case of non-parallel imaging, step 214 is not required, such that the method then directly ends in step 216 in which the corrected phase encoded image vectors are Fourier transformed which results in a final magnetic resonance image of the object. However, in case parallel imaging employing multiple receiving coil elements is performed, after step 210 either the steps 212 and 214 may be carried out or directly step 218 may alternatively be carried out.

Following in Fig. 2 the steps 212 and 214, after having calculated in step 212 the corrected phase encoded image vectors as described above, step 214 is followed in which new corrected phase encoded image vectors are calculated by adding a respective coil phase *P₀* to the phase of the corrected phase encoded image vectors obtained from step 212. Herein, preferably for given coil elements the coil phase is the phase of the gradient echo with smallest main magnetic field induced phase errors, obtained in step 202. I.e. in step 214 the corrected phases are calculated as *C_{0..n} ⁼ I_{0..n} ⁻ P_{0..n}* + *P₀*.

After step 214, the method finishes again in step 216, as described above.

In the alternative approach, step 210 is directly followed by step 218 which basically is a mixture of steps 212 and 214: in step 218, for each gradient echo time point the difference between the phase *P_{0..n}* of the phase navigator vector of said gradient echo at said echo time point and the phase *P₀* of the phase navigator vector of the determined gradient echo with the smallest main magnetic field induced phase error is calculated, i.e. *P₀ - P_{0..n}*, wherein said calculation results in a phase difference for each echo time point. By adding at each echo time point said phase difference to the corresponding phase of the phase encoded image vector, the new corrected phase encoded image vectors are obtained, i.e. *C_{0..n} ⁼ I_{0..n} + (P₀ - P_{0..n})*.

The method ends again in step 216, as described above.

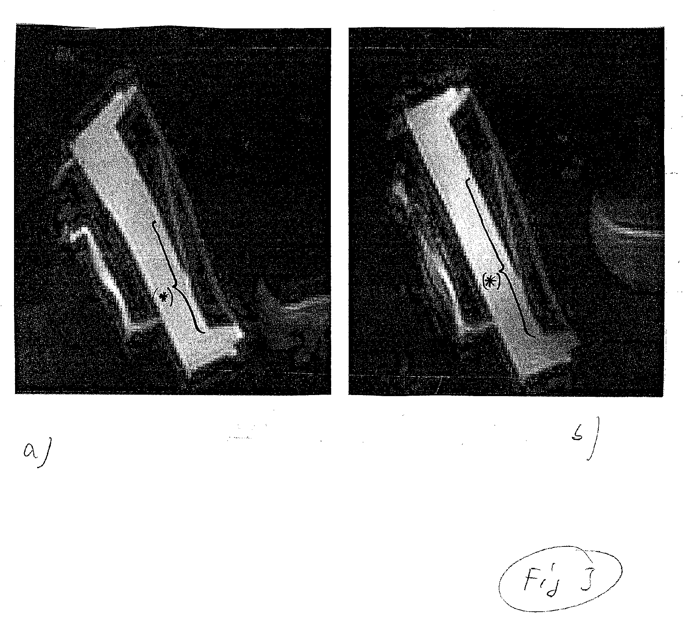

Fig. 3 illustrates a typical experimental result regarding EPI distortion correction of an object to be imaged. The displayed image contains of two phantoms, a water phantom to the left and a partially-filled spherical fat phantom to the right. The homogeneity of the magnetic field is distorted due to the shape of the phantoms. As a result, the EPI image is distorted, especially in the vertical direction, corresponding to the phase encode direction. In reality, the grey shaded area has rectangular shaped proportions, whereas in the normal EPI scan shown in Fig. 3a straight proportions of the image are banded due to local variations of B₀ and possibly Eddy current distortions.

The results in Fig 3a are based on state-of-the-art EPI reconstruction using phase corrections for positive and negative phase differences due to eddy currents for the gradient echo readouts so that the typical EPI ghosting is removed, but geometrical distortion are present. Notably the fat phantom is not only distorted but also displaced relative to its true position. In contrast, by application of the here disclosed method largely recovers, the true same proportions and locations of the phantom, denoted by a star appear in Fig. 3b as straight lines, thus reconstructing the real proportions of the object. Consequently, it can be concluded that the above method permits an EPI distortion correction and eddy current distortion corrections in a highly reliable manner.

## Claims

1. A method of acquiring a magnetic resonance image of an object (10) in a main magnetic field of a magnetic resonance scanner, the method comprising:
- performing (200) an echo planar imaging reference scan on the object (10), wherein said reference scan is acquired without phase encoding, said reference scan resulting in a set of gradient echoes,
- storing (202) the set of gradient echoes from said reference scan as a reference dataset for each gradient echo time point,
- performing (204) for each gradient echo time point a 1D Fourier transform of the reference dataset in the frequency encoding direction, said Fourier transforms resulting in a phase navigator vector for each gradient echo time point,
- performing (208) an echo planar imaging scan on the object (10), wherein said scan is acquired with phase encoding for each of the gradient echo time points, said echo planar imaging scan resulting in an image formation dataset,
- performing (210) for each of the gradient echo time points a 1D Fourier transform of the image formation dataset in the frequency encoding direction, said Fourier transforms resulting in a phase encoded image vector for each gradient echo time point,
- calculating (212, 218) corrected phase encoded image vectors for each gradient echo time point, said calculation comprising subtracting for each given gradient echo time point the phase of the phase navigator vector from the phase of the phase encoded image vector.

2. The method of claim 1, further comprising Fourier transforming (216) the corrected phase encoded image vectors resulting in a final magnetic resonance image of the object (10).

3. The method of claim 1 or 2, further comprising smoothing (206) the phase of the phase navigator vector, wherein smoothing comprises fitting the phases of a set of the phase navigator vectors for different gradient echo time points and smoothing the phases of the phase navigator vectors by the fit.

4. The method of claim 1, wherein the reference scan is based on spin echo or gradient echo excitations.

5. The method according to claim 1, wherein the magnetic resonance image data acquisition is performed by parallel imaging employing multiple receiving coil elements, wherein the calculation of the corrected phase encoded image vector is performed per coil element.

6. The method of claim 5, further comprising calculating (214, 218) new corrected phase encoded image vectors for each coil element, said calculation comprising adding (214, 218) the coil phase to the phases of the corrected phase encoded image vectors calculated for said coil element.

7. The method of claim 6, wherein adding the coil phase comprises for each coil element:
- determining for a given coil element the gradient echo of the set of gradient echoes with the smallest main magnetic field induced phase error,
- adding the phase of said determined gradient echo to each other phase of the corrected phase encoded image vectors calculated for said coil element, said adding resulting in the new corrected phase encoded image vectors.

8. The method of claim 7, wherein the steps of calculating the corrected phase encoded image vectors and calculating the new corrected phase encoded image vectors is performed by
- calculating for each gradient echo time point the difference between the phase of the phase navigator vector of said gradient echo at said echo time point and the phase of the phase navigator vector of the determined gradient echo with the smallest main magnetic field induced phase error, said calculation resulting in a phase difference for each echo time point,
- adding at each echo time point said phase difference to the corresponding phase of the phase encoded image vector, said adding resulting in the new corrected phase encoded image vectors.

9. The method of claim 7, wherein
- in case the reference scan is based on spin echo excitations, the gradient echo at the spin echo readout time is selected as the gradient echo with the smallest main magnetic field induced phase error,
- in case the reference scan is based on gradient echo excitations, the earliest gradient echo with the shortest echo time is selected as the gradient echo with the smallest main magnetic field induced phase error.

10. The method of claim 1, wherein said reference scan is acquired for subsequent gradient echo time points in opposite k-space directions.

11. The method of claim 1, wherein the method further comprises performing the echo planar imaging reference scan employing fat suppression, wherein the set of gradient echoes with fat suppression are used for the calculation of the phase navigator vectors.

12. The method of claim 11, wherein the method comprises:
- performing the echo planar imaging reference scan twice for different echo times resulting in two sets of gradient echoes,
- performing water/fat unfolding employing the two sets of gradient echoes, said unfolding resulting in a new set of gradient echoes,
- using said new set of gradient echoes for calculation of the phase navigator vectors,
- performing the echo planar imaging scan on the object (10) resulting in the image formation dataset,
- performing the 1D Fourier transform of the image formation dataset,
- calculating the corrected phase encoded image vectors for each gradient echo time point, said calculation comprising subtracting for each given gradient echo time point the phase of the new phase navigator vector from the phase of the phase encoded image vector.

13. A computer program product comprising computer executable instructions to perform the method steps as claimed in any of the previous claims.

14. A magnetic resonance imaging system (1) for acquiring a magnetic resonance image of an object (10) in an examination volume of a magnetic resonance scanner, said scanner comprising a main magnet (2) for providing a main magnetic field within the examination volume, wherein the system is adapted for:
- performing (200) an echo planar imaging reference scan on the object (10), wherein said reference scan is acquired without phase encoding, said reference scan resulting in a set of gradient echoes,
- storing (202) the set of gradient echoes from said reference scan as a reference dataset for each gradient echo time point,
- performing (204) for each gradient echo time point a 1D Fourier transform of the reference dataset in the frequency encoding direction, said Fourier transforms resulting in a phase navigator vector for each gradient echo time point,
- performing (208) an echo planar imaging scan on the object (10), wherein said scan is acquired with phase encoding for each of the gradient echo time points, said echo planar imaging scan resulting in an image formation dataset,
- performing (210) for each of the gradient echo time points a 1D Fourier transform of the image formation dataset in the frequency encoding direction, said Fourier transforms resulting in a phase encoded image vector for each gradient echo time point,
- calculating (212, 218) corrected phase encoded image vectors for each gradient echo time point, said calculation comprising subtracting for each given gradient echo time point the phase of the phase navigator vector from the phase of the phase encoded image vector.
